Europäisches Patentamt

European Patent Office

Office européen des brevets

(11) Publication number: **0 337 823**
A2

# EUROPEAN PATENT APPLICATION

(21) Application number: 89303798.6

(22) Date of filing: 17.04.89

(51) Int. Cl.4: **H 01 L 29/06**
H 01 L 29/78

(30) Priority: 15.04.88 JP 91773/88

(43) Date of publication of application:
18.10.89 Bulletin 89/42

(84) Designated Contracting States: **DE FR GB**

(71) Applicant: KABUSHIKI KAISHA TOSHIBA
72, Horikawa-cho Saiwai-ku
Kawasaki-shi Kanagawa-ken 210 (JP)

(72) Inventor: Shirai, Koji Intellectual Property Division
Toshiba Corporation Principal Office
1-1-1, Shibaura Minato-ku Tokyo (JP)

(74) Representative: Sturt, Clifford Mark et al
MARKS & CLERK 57-60 Lincoln's Inn Fields
London WC2A 3LS (GB)

(54) MOS field effect transistor having high breakdown voltage.

(57) A semiconductor device of the MOS FET type which has a high withstand voltage having first (6) and second (5) regions of first and second conductivity types serving as P and N wells respectively, a third region (8) extending from the second region (5) and separated from the first region (6) by 2 μm to 10 μm. Concentration of electric field is avoided, yet a depletion layer is produced in the N-well layer during operation ensuring a high break down voltage.

FIG.2.

## Description

## MOS FIELD EFFECT TRANSISTOR HAVING A HIGH BREAKDOWN VOLTAGE

The present invention relates to MOS field effect transistors as may be used in output circuits which require a high break down voltage.

The lightly doped drain (LDD) is widely used for achieving a high break down voltage and high speed MOS FET.

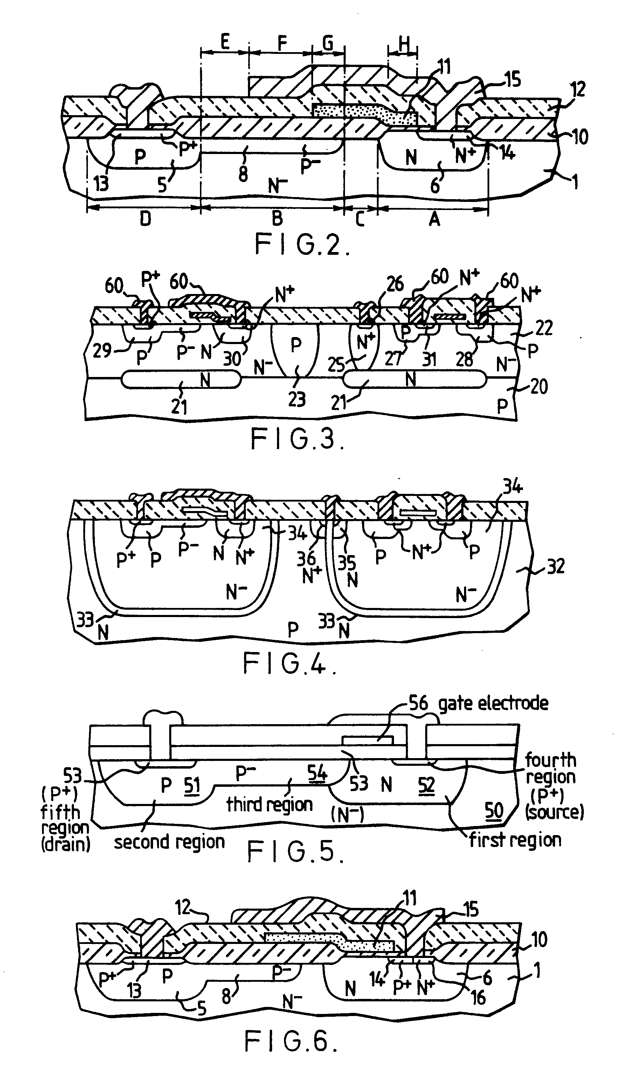

A P channel MOS FET is shown in Figure 5 which is representative of a well-known structure intended for achieving high break down voltage. A P-well layer 51 and N-well layer 52 are locally formed on an N conductive type semiconductor substrate 50 thereby respectively forming the drain and source regions of the FET. Prior to formation of these regions, an oxide film is formed on the surface of the semiconductor substrate 50 by for instance steam oxidation according to a well-known method. The oxide film is formed as a thin film by an etching process over the drain and source to a thickness of approximately 1000 angstroms, and boron and phosphorus are implanted respectively into the locations where the P-well layer 51 is to be formed and where N-well layer 52 is to be formed using an ion-implantation process.

The oxide film is then removed by etching, and after locally forming P-well layer 51 and N-well layer 52 by a thermal diffusion process, the entire surface of the semiconductor substrate 50 is newly covered by a 1000 angstrom thick gate oxide layer 53. The P region 54 functions to increase the withstand voltage of the surface portion of the semiconductor substrate 50.

The gate layer is provided by forming a multi-crystal silicon layer 56. The gate layer is made through a patterning process after forming the multi-crystal silicon layer 56 on the semiconductor substrate 50 on which the above-mentioned oxide layer 53 is formed. Furthermore, aluminium contacts 58 and 59 are placed over both well layers and electrodes are formed according to a standard method.

The MOS FET which is thereby formed as shown in Figure 5, is configured with N-well layer 52 in contact with the end of the P region 54. This structural arrangement occurs as a result of the heat treatment conducted at the time of the ion implantation of P region 54. The electric field is concentrated at the PN junction making if difficult to increase the break down voltage of this P region 54.

Accordingly, an object of this invention is to provide a high break down voltage FET that eliminates this problem and in particular makes it possible to form high break down voltage P channel MOS FETs in the same process as for forming high break down voltage N channel D-MOS FETs.

To achieve the above purpose, the present invention adopts a method to form the P region and the N-well region in a non-contacting, separated relationship. According to this invention, in a P channel MOS FET a P layer is formed in the P-well region and used as a drain and an N layer is formed in the N-well region and used as the source. A thick oxide layer is formed on the field portion between the two well layers. A thin gate oxide layer covers the N-well region and multi-crystal silicon is laminated to extend over the thick oxide layer.

Adjacent the P layer that constitutes the drain region, a P layer of lower concentration than the first P layer is formed under the thick oxide layer. The end of this layer however does not come in contact with the N-well layer comprising the source region. Therefore, concentration of the electric field between the P layer and the N-well layer is prevented since there is no PN junction. At the same time the depletion layer that is produced in the N-well layer with the operation of the MOS FET insures high break down voltage. Therefore, the MOS FET of the present invention performs nearly the same functions as those of the LDD device, and furthermore, higher break down voltage and high speed operation are simultaneously achieved.

Embodiments of the invention will now be described by way of example only and with reference to the accompanying drawings, in which:-

Figures 1a - 1k are sectional views showing the process of making a preferred embodiment of the present invention,

Figure 2 shows preferred spacings of the regions of preferred embodiment shown in Figure 1k,

Figure 3 is a cross sectional view of another embodiment of the present invention,

Figure 4 is a cross section of yet another embodiment of the present invention,

Figure 5 is a sectional view of a conventional MOS FET, and

Figure 6 is a cross sectional view of a preferred embodiment of the present invention.

Details of the several embodiments of the present invention are now explained with reference to the Figures.

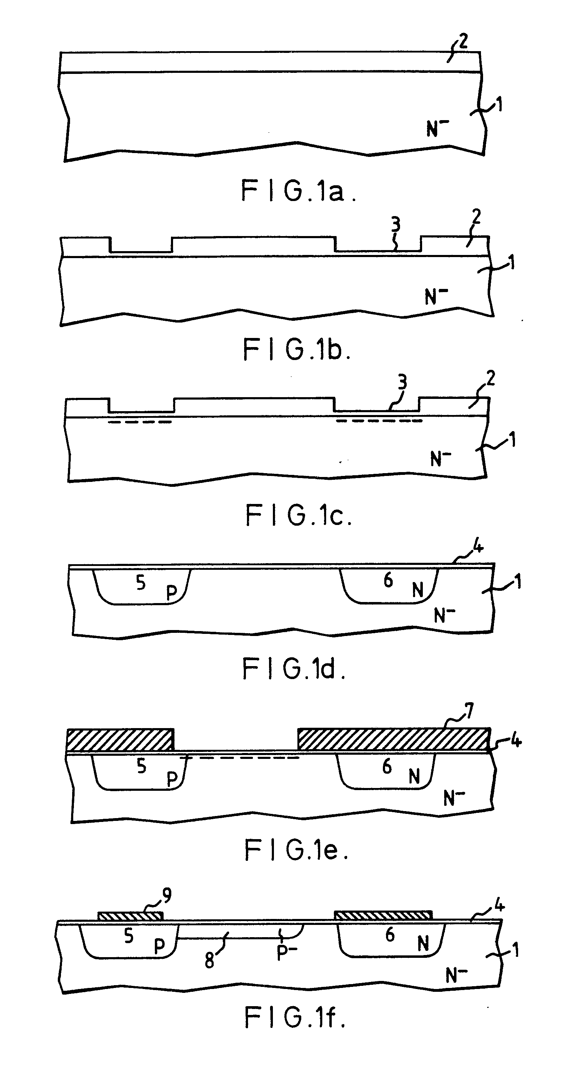

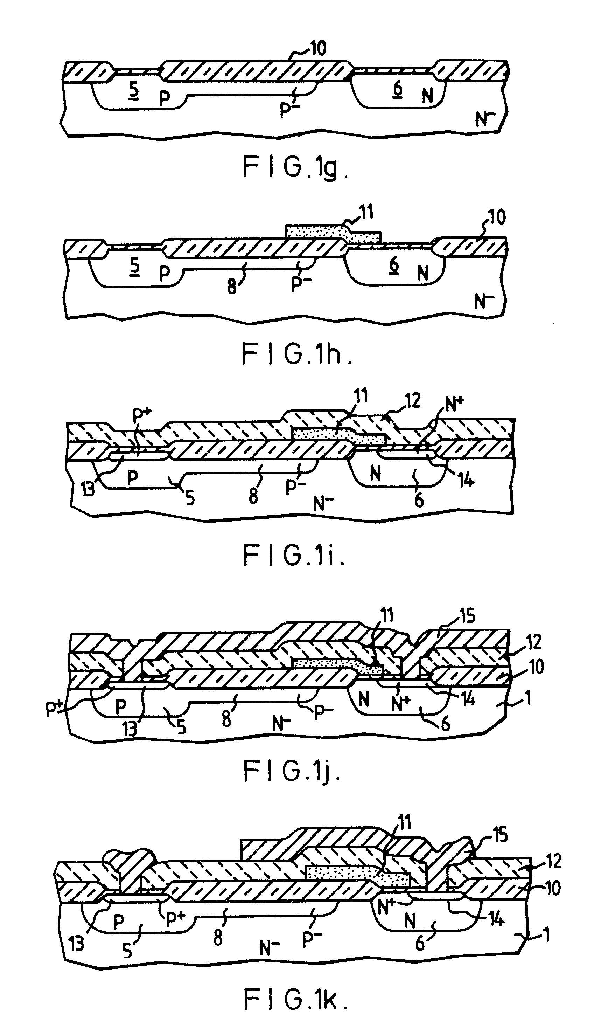

An N substrate 1 containing phosphorus as an impurity of $5 \times 10^{12} cm^{-3}$ is prepared and is covered with a silicon oxide layer 2 of approximately 5000 angstrom thickness as shown in Figure 1a. The oxide layer 2 is formed by an oxidizing step in a steam atmosphere at approximately 1000°C.

After forming apertures in oxide layer 2 (not illustrated) corresponding to locations where the drain and source regions will be formed, a silicon oxide layer 3, having a thickness of only 1000 angstroms is formed over the apertures by oxidizing the substrate in the steam atmosphere at about 1000°C as shown in Figure 1b.

As shown in Figure 1c, boron is implanted to form a drain region and phosphorus is implanted to form a source region through the thin silicon oxide layer 3 according to an ion implantation process. The implantation of boron uses a dose quantity of $5 \times 10^{12} cm^{-2}$ at 60 KeV, and the implantation of the phosphorus uses a dose quantity of $5 \times 10^{12} cm^{-2}$ at 160 KeV. The apertures through which the ion implantation is performed are closed by a resist layer (not illustrated).

The next step in the process is to heat treat the semiconductor substrate for 12 hours in a nitrogen atmosphere maintained at 1200°C. The entire silicon oxide layer coated on the surface of the substrate is removed using hydrofluoric acid, and the 1000 angstrom silicon oxide layer 4 is newly formed on the substrate through steam oxidation at 1000°C as shown in Figure 1d. As a result of this step, the P-well layer 5 serving as the drain region and the N-well layer 6 serving as the source region are formed as shown in Figure 1d.

Next recessed layer 7 is formed on the substrate 1 except for a space between the P-well layer 5 and the end of the N-well layer 6. After implanting boron ions at a dose quantity of $2 \times 10^{12} cm^{-2}$ at 80 KeV, the substrate is heated for 2 hours in a nitrogen atmosphere kept at approximately 1100°C. P region 8 is thereby formed at a lower concentration than drain region 5. Preferably P region 8 is separated from source region 6 by 2-10 um. The cross sectional view of the region is shown in Figure 1e.

A silicon nitride layer is deposited on the P and N-well layers 5 and 6, and a local oxidation mask 9 is formed by patterning the silicon nitride layer as shown in Figure 1f.

Next the substrate is steam oxidized at approximately 1000°C, and a 7000 angstrom thick local oxide layer 10 is formed as shown in Figure 1g.

After the silicon nitride layer that functions as the local oxidation mask 9 is removed by a dry etching process, a 5000 angstrom thick multi-crystal silicon layer 11 is formed, and portions are removed by a patterning process except for that shown in Figure 1h. Then, following ion implantation of boron at a dose level of $5 \times 10^{15} cm^{-2}$ at 60 KeV through the gate oxide layer 4 with the multi-crystal silicon layer 10 acting as a mask, the CVD silicon oxide layer 12 is heat treated for 30min. in an oxygen atmosphere maintained at 1000°C. The resulting MOS FET has drain region 13 and source region 14 as shown in Figure 1i. The thickness of the P region comprising drain region 13 and source region 14 is held as thin as 0.8 um in order to maintain the high speed characteristic.

After apertures are formed for contact on the CVD silicon oxide layer 12 by a photo engraving process (PEP), the 2.0 um thick aluminium layer 15 is laminated on top of the oxide layer 12 as shown in Figure 1j. Furthermore, patterning is applied according to the PEP process as shown in Figure 1k. After a sintering process is carried on for 30 min. in a nitrogen atmosphere kept at 450°C, a PSG film (not illustrated) is formed according to the CVD process to complete the P channel MOS FET of the present invention.

The embodiment of Figure 1k is shown in Figure 2 with preferred spacings between regions shown. Preferably distance A across region 6 is about 20 um. The distance B across region 8 is preferably about 12 um and the distance C between regions 6 and 8 is preferably 2 to 10 um. Distance D across region 5 is preferably 12 um. Distance H is preferably 2 to 3 um. Distances E, F and G which span region 8 are preferably equal to one another.

As can be seen in Figure 2, in order to protect the electric field concentration in the third region 8, the first electrode 15 extends over region 8 a distance twice as large (A + B) as a second distance (B) of the extended portion of the gate electrode 11 covering third region 8. The distance C which extends from the edge of the first electrode 15 to the junction between the second region 5 and the third region 8 is then equal to distance A. This structure protects the electric field concentration in third region 8 and a high breakdown voltage is thereby obtained.

An example of a P channel MOS FET of the present invention formed with a N channel D-MOS FET monolithically on the P semiconductor substrate 20 is shown in Figure 3. The P type semiconductor substrate 20 contains boron at about a $5 \times 10^{14} cm^{-2}$ dose quantity as an impurity. Since devices similar to those of the P channel MOS FET shown in Figures 1a - 1k are formed on this substrate, the same method is applied as described above and nitrogen buried region 21 containing $1 \times 10^{18} cm^{-3}$ of antimony (Sb) are formed in a standard way in order to assure complete separation of the devices.

After forming the regions at the specified positions on the surface of the P type semiconductor substrate 20 by introducing antimony, the N epitaxial layer 22 is formed according to an epitaxial growth process. Island regions are separated by device isolation region 23.

A P channel MOS FET is formed on one of the island regions and an N channel D-MOS FET is formed on the other island region as shown in Figure 3. The detailed explanation of the formation of the former is omitted as its manufacturing method and structure are substantially equivalent to that shown in Figures 1a -1k.

For the N channel D-MOS FET, a deep $N^+$ layer 25 is formed using phosphorus. The $N^+$ layer 26 is formed in the deep $N^+$ layer 25. Drain and source terminals 60 are formed by deposition of aluminium. To form the N channel D-MOS FET, the P-well layers 27 and 28 are formed concurrently with the formation of the P-well layers 29 and 30 of the P channel MOS FET.

To form $N^+$ region 31 in the P-well layer 27, N channel D-MOS FET is completed by introducing arsenic into the region. The electrode is formed in the same manner as previously explained. This process differs from the example shown in Figures 1a - 1k since a thermal oxide film is used instead of a local oxide layer. The difference between these processes is shown by indicating a flat oxide film in the figure but the detailed explanation is omitted as the process is well known.

Figure 4 shows a cross section of a device in which the epitaxial growth layer is formed at specific locations on the P semiconductor substrate 32. Thus 2 holes of a 50 $um^3$ area are provided at specific locations of the silicon P semiconductor substrate 32 by an isotropic etching process using hydrofluoric acid and nitric acid. The N buried regions 33 are formed on the exposed silicon P semiconductor substrate 32. The N buried regions 33 are formed in the same manner as regions 21 are formed in Figure 2. After forming the isolation regions by depositing the epitaxial growth layer 34, having a dose concentration of $5 \times 10^{14} \text{cm}^{-3}$ of phosphorus, the N channel D-MOS FET in the P channel MOS FET are formed monolithically on the P semiconductor substrate 32 in the same manner as in Figure 2.

The P-well layer for the N channel D-MOS FET shown in each of Figures 3 and 4 contains boron of about a concentration level of $10^{15} \text{cm}^2$ and the $N^+$ layer contains arsenic at a concentration level of about $10^{20} \text{cm}^{-3}$. The $N^+$ region 36 is provided in the N-well region 35 which is formed at the end of the buried region 33 for the N channel D-MOS FET. The drain electrode is connected to the $N^+$ region 36. The $N^+$ region 36 has a high impurity density to reduce contact resistance. But a high impurity density region results in early breakdown. So N-well region (low impurity density region) 35 is provided around the $N^+$ region 36 for preventing a drop of breakdown voltage caused by N region 36.

Another embodiment is shown in Figure 6. This embodiment is a modification of the embodiment of Figure 1. The first region 6 of Figure 1 is electrically floating. Therefore the P channel formed in the first region 6 lacks voltage stability. In the embodiment of Figure 6 a sixth region 16 is provided for connecting first electrode 15 and first region 16 thereby stabilizing the voltage of the first region 6. As a result of stabilizing the voltage of first region 6, the P channel which is formed in the first region 6 is stablized.

In the past, break down voltage of MOS devices has been achieved by (1) reducing the density of the impurity in diffusion layers comprising the device, (2) making the depth from the surface of the PN junction deeper, and (3) making the thickness of the insulator of the field portion thicker. However, the first technique may result in reduction of yield since it is extremely difficult to control the density of the impurity; the second technique requires a reduction in the through-put of the process because the heat treatment time becomes longer and therefore costs are increased; the final technique may cause cracks because of the difference in coefficients of thermal expansion between silicon substrates, if the silicon oxide film is formed too thick.

According to the present invention, however, high speed and high break down voltage of about 1000V are attainable in an MOS FET by reducing the distance of the discontinuous part between the P region and the N-well region to about 10 um. This is done while keeping the density and depth of the impurity added layer for the PN junction at the same values as before.

## Claims

1. A field effect transistor device utilized for an output circuit of a high withstand voltage IC which comprises:
semiconductor layer of a first conductivity type;
a first region of the first conductivity type within said semiconductor layer having higher doping concentration than that of said semiconductor layer;
a second region of a second conductivity type within said semiconductor layer set apart from said first region having higher doping concentration than that of said semiconductor layer;
a third region of the second conductivity type which contacts with said second region and extends toward said first region having lower doping concentration than that of said second region, said third region being separated from said first region by a distance of 2 µm to 10 µm, for providing high withstand voltage;
a fourth region of the second conductivity type within said first region having a higher doping concentration than that of said first region;
a fifth region of the second conductivity type within said second region having a higher doping concentration than that of said second region;
a first insulating layer having a first thicker portion on said third region and extending between said first region and said third region and a second thinner portion extending over said first region;
a gate electrode on said first insulating layer extending over said first portion to said second portion;
a second insulating layer covering said gate electrode;
a first electrode contacted with said fourth region; and
a second electrode contacted with said fifth region.

2. The field effect transistor device according to claim 1, wherein the first electrode has an extending portion covering the gate electrode over said second insulating layer.

3. The field effect transistor device according to claim 2, wherein a first distance of the extending portion of said first portion which covers said third region is twice the distance of the extending portion of the gate electrode which covers the third region, and a third distance of a part of said third region which is from the edge of the extending portion of the first electrode to the junction between the second region and the third region is equal to the second distance.

4. The field effect transistor device according to claim 1, further comprising a wiring pattern covering the third region and the gate electrode to which a potential substantially equal to that of the first electrode is applied.

5. The field effect transistor device according to claim 1, further comprising a sixth region in said first region which is electrically connected with said fourth region and has higher doping concentration of said first conductivity type than that of said first region.

F I G.1a.

F I G.1b.

F I G.1c.

F I G.1d.

F I G.1e.

F I G.1f.

F I G.1g.

F I G.1h.

F I G.1i.

F I G.1j.

F I G.1k.

FIG.2.

FIG.3.

FIG.4.

56 gate electrode

53
(P+)
fifth
region
(drain)

P 51    P⁻    54    53 N    52

third region

second region    (N⁻)

fourth
region
(P+)
(source)

50

first region

FIG.5.

12    11    15

P+    P    P⁻    N    14 P+ N+    6    1

13    8    16

5    N⁻

FIG.6.